# EUROPÄISCHE PATENTSCHRIFT

(11) **EP 0 505 776 B1**
(45) Veröffentlichungstag und Bekanntmachung des Hinweises auf die Patenterteilung: **05.06.1996**
(21) Anmeldenummer: 92103720.6
(22) Anmeldetag: 05.03.1992
(51) Int. Cl.: G01R 29/26, H01L 21/66

(54) **Verfahren und Vorrichtung zur Beschichtung eines optoelektronischen Bauelements**
Process and apparatus for the application of a layer on an opto-electronic component
Procédé et dispositif pour appliquer une couche sur un composant opto-électronique

(30) Priorität: 25.03.1991 DE 4109727
(43) Veröffentlichungstag der Anmeldung: 30.09.1992
(73) Patentinhaber: Alcatel SEL Aktiengesellschaft, D-70435 Stuttgart (DE); ALCATEL N.V., NL-1077 XX Amsterdam (NL)
(72) Erfinder: Idler, Wilfried, W-7144 Asperg (DE)
(74) Vertreter: Hösch, Günther, Dipl.-Ing.

(56) Entgegenhaltungen:
- DE-A- 3 802 841

## Beschreibung

Die Erfindung betrifft ein Verfahren zur Beschichtung eines optoelektronischen Bauelements nach dem Oberbegriff des Patentanspruchs 1 und eine Vorrichtung zur Durchführung des Verfahrens nach dem Oberbegriff des Patentanspruchs 4.

Aus Appl. Optics 26 (1987), S. 845 - 849, ist ein Verfahren zur Beschichtung von Halbleiterlasern mit Antireflex-Schichten bekannt, d.h. insbesondere von Halbleiterlasern, die in einem System zur kohärenten optischen Übertragung Verwendung finden sollen. Dabei muß die Oberflächenreflexion an den Lichtaustrittsseiten minimiert werden, insbesondere wenn der Halbleiterlaser Teil eines externen Resonators ist. Der Brechungsindex der Schicht muß in Hinsicht auf die Wellenlänge des aus dem Halbleiterlaser ausgesandten Laserlichts und den Brechungsindex der Wellenleiterschicht des Halbleiterlasers gewählt werden.

Ein Halbleiterlaser, der sich in einer Reaktionskammer eines Beschichtungsreaktors befindet, wird mit Siliziumnitrid beschichtet. Während der Beschichtung wird an den Halbleiterlaser ein Wechselstrom angelegt, und das von dem Halbleiterlaser dabei emittierte Licht wird, durch ein Interferenzfilter gefiltert, von einer Photodiode gemessen, die sich außerhalb der Reaktionskammer befindet. Das von der Photodiode erzeugte elektrische Signal wird in einem Umformer symmetrisch gemacht und einem Lock-in-Verstärker zugeführt. Aus dessen Ausgangssignal lassen sich dann Reflexionsvermögen und Schichtdicken der Schichten ermitteln.

Nachteilhaft an diesem Verfahren ist der hohe experimentelle Aufwand zur Ermittlung der Schichtdicken, die erst durch Umwandlung und Rückumwandlung zwischen elektrischen und optischen Signalen gelingt.

Aus der DE 38 02 841 A1 ist ein Verfahren zur Auswertung von elektrischen Rauschspektren bekannt, mit dem sich die optischen Eigenschaften von Halbleiterlasern bestimmen lassen. Jedoch bezieht sich dieses Verfahren ausschließlich auf bereits fertig hergestellte Halbleiterlaser. Es wird kein Hinweis auf Herstellungsschritte von Halbleiterlasern unter Auswertung von Rauschspektren gegeben.

Es ist die Aufgabe der Erfindung, ein Verfahren und eine Vorrichtung zur Durchführung des Verfahrens zu schaffen, wodurch sich die Bestimmung der Schichtdicke vereinfacht.

Die Aufgabe wird, wie in Patentanspruch 1 bzw. 4 angegeben, gelöst.

Vorteilhaft an der Erfindung ist, daß optische Bauelemente, z.B. ein Gitterspektrometer, das als Interferometer dient, und eine Photodiode zur Messung des von dem Bauelement emittierten Lichtes entfallen, und damit auch die Probleme bei der Fokussierung des Laserlichts auf das Gitterspektrometer. Mit der neuen Vorrichtung können optoelektronische Bauelemente, insbesondere Halbleiterlaser, gebaut werden, die genau bestimmte Schichtdicken der Schichten auf den Lichtaustrittsseiten haben. Diese Halbleiterlaser gewährleisten je nach Verwendungszweck, z.B. als Sendelaser oder als Wanderwellenverstärker, eine hohe optische Verstärkung.

Die Erfindung wird nachstehend anhand der Zeichnungen beispielsweise erläutert. Soweit die Erfindung ein Verfahren zur Beschichtung eines Bauelements betrifft, wird es im Zusammenhang mit der Beschreibung der Vorrichtung zur Durchführung des Verfahrens erläutert. Es zeigen:
- Fig. 1: die Vorrichtung zur Beschichtung,
- Fig. 2: einen von einer Stromquelle erzeugten, in einem Zeitintervall jeweils gleichmäßig ansteigenden Meßstrom als Funktion der Zeit,
- Fig. 3: einen von der Stromquelle erzeugten, in einem Zeitintervall jeweils in Pulsen ansteigenden Meßstrom als Funktion der Zeit,
- Fig. 4: Fabry-Pérot-Halbleiterlaser auf einem Riegel im Querschnitt,
- Fig. 5: die elektrische Rauschleistung eines Fabry-Pérot-Halbleiterlasers bei einem ersten Beschichtungsvorgang als Funktion des an ihn angelegten Meßstroms,
- Fig. 6: die Reflektivität des Fabry-Pérot-Halbleiterlaser als Funktion der Schichtdicke der während des ersten Beschichtungsvorgangs aufgebrachten dielektrischen Schicht,
- Fig. 7: die elektrische Rauschleistung des Fabry-Pérot-Halbleiterlasers bei einem zweiten Beschichtungsvorgang als Funktion des an ihn angelegten Meßstroms,
- Fig. 8: die Reflektivität des Fabry-Pérot-Halbleiterlasers als Dunktion der Schichtdicke der während des zweiten Beschichtungsvorgangs aufgebrachten dielektrischen Schicht,
- Fig. 9: die elektrische Rauschleistung eines DFB-Halbleiterlasers vor der Beschichtung als Funktion eines an ihn angelegten Meßstroms und
- Fig. 10: die elektrische Rauschleistung des DFB-Halbleiterlasers nach der Beschichtung als Funktion des an ihn angelegten Meßstroms.

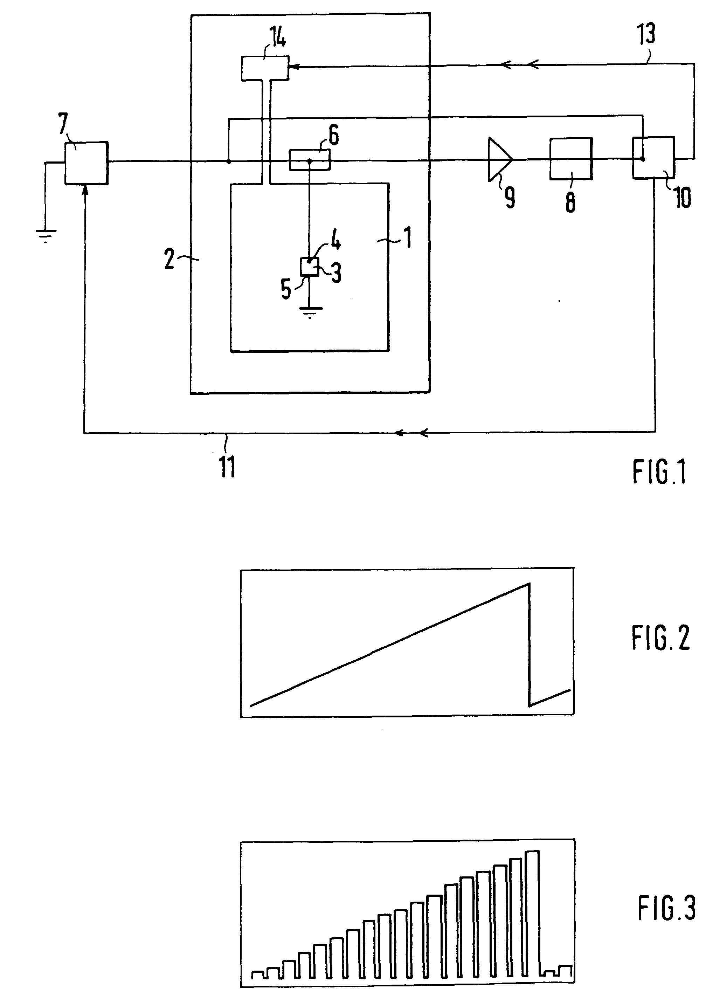

Eine in Fig. 1 gezeigte Vorrichtung zur Beschichtung von optoelektrischen Bauelementen weist einen mit einer Reaktionskammer 1 ausgestatteten Beschichtungsreaktor 2 auf. In der Reaktionskammer 1 befindet sich wenigstens ein einziges optoelektronisches Bauelement 3, das mit wenigstens einer dielektrischen Schicht beschichtet werden soll. Im Normalfall werden viele Bauelemente 3 gleichzeitig beschichtet, die entweder auf einem Wafer neben- uund hintereinander oder auf einem Riegel mit ihren Längsseiten nebeneinander liegen.

Auf dem Wafer befindet sich etwa 5.000 bis 10.000 Halbleiterlaser, z.B. Fabry-Pérot-Halbleiterlaser. Auf dem Riegel sind beispielsweise 40 bis 50 DFB(= Distributed Feedback)-Halbleiterlaser angeordnet.

Das Bauelement 3 hat auf seiner Ober- und seiner Unterseite jeweils einen elektrischen Anschluß 4, 5. Auf seiner Unterseite weist das Bauelement vorzugsweise eine Metallisierung auf, die den Anschluß 4 bildet, dieser ist vorzugsweise der elektrische Masseanschluß. Über den Anschluß 4 auf der Oberseite ist das Bauelement 3 mit einer Verzweigungsschaltung 6 verbunden, die auch als "Bias-T" bezeichnet wird.

Diese ist ihrerseits mit einer Stromquelle 7 und mit einem Spektralanalysator 8 verbunden.

Das optoelektronische Bauelement 3, das beispielsweise entweder ein Fabry-Pérot-Halbleiterlaser, ein DFB-Halbleiterlaser oder ein optischer Wanderwellenverstärker ist, wird in wenigstens einem Beschichtungsschritt mit einer dielektrischen Schicht beschichtet, die einen wesentlichen Einfluß auf die optische Parameter des Bauelements hat. Diese besteht beispielsweise aus Siliziumnitrid (Si₃N₄) oder einem Siliziumoxid (SiOₓ).

Während dieses Beschichtungsschritts oder dieser Beschichtungsschritte fließt nun aus der Stromquelle 7 über die Verzweigungsschaltung 6 ein Meßstrom durch das Bauelement 3 auf den Masseanschluß. Während der Meßstrom durch das Bauelement 3 fließt, entstehen in diesem Rauschsignale, die sich dem Meßstrom überlagern und die die optischen Parameter enthalten.

In der Verzweigungsschaltung 6 trennt die Rauschsignale elektrisch von dem Meßstrom und ist in Richtung zu dem Spektralanalysator 8 nur für die Rauschsignale durchlässig. Ein stark vereinfachtes Beispiel für die Verzweigungsschaltung 6 ist ein dem Spektralanalysator 8 vorgeschalteter Kondensator. Die Verzweigungsschaltung 6 ist vorzugsweise nur für Rauschsignale im Hochfrequenzbereich, z.B. oberhalb von 100 MHz durchlässig, um auch diejenigen Rauschsignale zu unterdrücken, die von störenden Radioquellen oder anderen elektrischen Komponenten als von dem Bauelement 3 hervorgerufen werden. Der Spektralanalysator 8 nimmt das elektrische Rauschspektrum vorzugsweise in einem schmalen Frequenzbereich von z.B. 3 MHz um eine mittlere Frequenz von z.B. 150 MHz auf, indem er die elektrische Rauschleistung des Bauelements 3 mißt.

Zwischen dem Spektralanalysator 8 und der Verzweigungsschaltung 6 wird vorzugsweise ein elektrischer Verstärker 9 angebracht, um die Rauschleistung zu verstärken.

Die von dem Spektralanalysator 8 gemessene elektrische Rauschleistung wird zu einem Steuerrechner 10 übertragen. Dieser steuert die Stromquelle 7 über eine Steuerleitung 11.

Aufgrund von Steuersignalen des Steuerrechners 10 erzeugt die Stromquelle 7 beispielsweise einen sägezahn förmigen Meßstrom, der in gleichen Zeitintervallen von einem Minimalwert mit konstanter Steigung auf einen Maximalwert ansteigt. Ein derartiger Meßstrom ist als Funktion der Zeit in Fig. 2 dargestellt.

In einem anderen Fall (Fig. 3) steigt der sägezahn förmigen Meßstrom während des gleichen Zeitintervalls in Rechteckpulsen an, bis er den Maximalwert erreicht. Danach beginnt er von neuem bei dem Minimalwert.

Der von der Stromquelle erzeugte Meßstrom wird dem Steuerrechner 10 über eine Leitung 12 zugeführt.

Damit gewinnt der Steuerrechner 8 die elektrische Rauschleistung des Bauelements 3 als Funktion des durch es fließenden Meßstroms. Aus dieser leitet er ein Signal zur Steuerung der Schichtdicke der dielektrischen Schicht ab. Dieses Signal wird über eine Steuerleitung 13 einer Beschichtungsanordnung 14 zugeführt, die ebenfalls Teil des Beschichtungsreaktors 10 ist. In der Beschichtungsanordnung 14 wird aufgrund dieses Signals der Reaktionskammer 1 weiterhin Material zur Beschichtung des Bauelements 3 zugeführt, oder der Beschichtungsvorgang wird beendet. Wenn mehrere Materialien gleichzeitig oder nacheinander für die Beschichtung mit der dielektrischen Schicht vorgesehen werden, kann sich aufgrund des Signals entweder die Zusammensetzung des Materials für die Beschichtung ändern, oder es wird der Zeitpunkt für den Wechsel des Materials, durch das die Beschichtung gerade erfolgt, durch das Signal des Steuerrechner 8 vorgegeben.

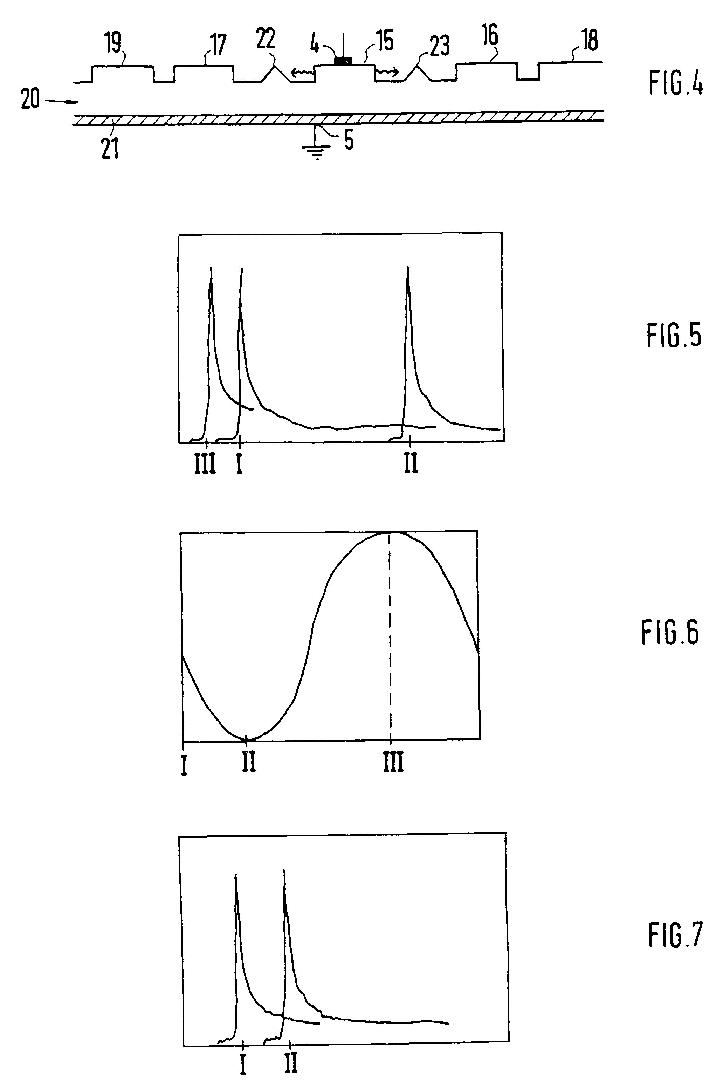

Mit dieser Vorrichtung lassen sich beispielsweise Fabry-Pérot-Halbleiterlaser 15-19 beschichten, wie sie in Fig. 4 dargestellt sind. Die Fabry-Pérot-Halbleiterlaser 15-19 sollen durch die Beschichtung auf ihrer vorderen Lichtaustrittsseite eine hohe und auf ihrer hinteren Lichtaustrittsseite eine niedrige Lichtausgangsleistung haben.

Die Fabry-Pérot-Halbleiterlaser 15-19 befinden sich auf einem Wafer 20, der auf seiner Unterseite eine als Masseanschluß dienende und dem Anschluß 5 gemäß Fig. 1 entsprechende Kontaktschicht 21 hat. Nur der Fabry-Pérot-Halbleiterlaser 15 weist den elektrischen Anschluß 4 auf, über den während der Beschichtung mit der dielektrischen Schicht der Meßstrom zu der Kontaktschicht 21 fließt. In diesem Fall ist der Fabry-Pérot-Halbleiterlaser 15 das optoelektronische Bauelement 3 gemäß der Darstellung in Fig. 1, das zur Bestimmung der Schichtdicke der Schicht ausgewählt ist, weil alle Fabry-Pérot-Halbleiterlaser 15-19 auf dem Wafer 20 genügend homogen aufgebaut sind und während des Beschichtungsvorgangs gleichmäßig mit der Schicht beschichtet werden.

Wenn nun durch den mit den elektrischen Anschlüssen 4, 5 versehenen Fabry-Pérot-Halbleiterlaser 15 ein Meßstrom fließt, emittiert er aus seiner Wellenleiterschicht aus seinen Lichtaustrittsseiten Licht. Um zu verhindern, das dieses in ihn von den ihm benachbarten Fabry-Pérot-Halbleiterlasern 16, 17 zurückreflektiert wird, sind zwischen ihren Lichtaustrittsseiten auf dem Wafer 20 Erhebungen 22, 23 mit dreieckförmigem Querschnitt vorhanden, die dies verhindern.

Weil die Fabry-Pérot-Halbleiterlaser 15-19 je eine stark verspiegelte und eine stark entspiegelte Lichtaustrittsseite haben sollen, werden sie in einem ersten Beschichtungsvorgang an je einer Lichtaustrittsseite mit einer Schutzschicht abgedeckt, um die Niederschlagung der dielektrischen Schicht auf diese Lichtaustrittsseite zu verhindern.

In Fig. 5 ist die Rauschleistung des Fabry-Pérot-Halbleiterlasers 15 als Funktion des an ihn angelegten Meßstrom abgebildet, wie sie der Steuerrechner 10 ermittelt. Diese ist vor der Beschichtung durch eine Kurve mit einem Peak I wiedergegeben, der dem Schwellstrom des Fabry-Pérot-Halbleiterlaser 15 entspricht.

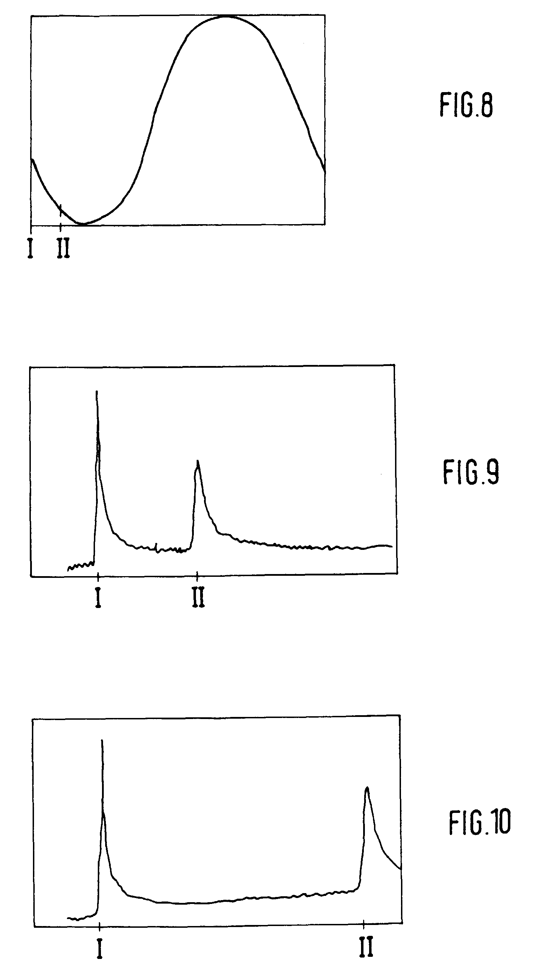

In einer Darstellung der Reflektivität des Fabry-Pérot-Halbleiterlasers 15 als Funktion der Schichtdicke in Fig. 6 korrespondiert zu dem Peak I ein Anfangswert der Reflektivität. Die Reflektivität ist definiert als Quotient der an der Lichtaustrittsseite reflektierten Lichtintensität zu der auf sie eingestrahlten Lichtintensität. Die Reflektivität ist eine mit der Schichtdicke der dielektrischen Schicht periodische Funktion.

Wenn nun während der Bedampfung eine gewisse Schichtdicke der dielektrischen Schicht erreicht wird, verschiebt sich das Maximum der Kurve in Fig. 5 zu einem Peak II, der einem höheren Schwellstrom entspricht. Dazu korrespondiert ein Minimum II der Reflektivität in Fig. 6. Bei weiterer Beschichtung wird sich das Maximum der Kurve in Fig. 5 zu einem einem Minimum des Schwellstroms entsprechenden Peak III verschieben, der einem Maximum III der Reflektivität entspricht. Damit ist eine stark verspiegelte Lichtaustrittsseite der Fabry-Pérot-Halbleiterlaser 15-19 hergestellt, aus der höchstens 5 % der Lichtintensität heraustreten kann.

Anschließend wird durch Wegätzen die Schutzschicht entfernt, die die jeweils andere Lichtaustrittsseite der Fabry-Pérot-Halbleiterlaser 15-19 bedeckt hatte, und die bereits beschichtete Lichtaustrittsseite durch eine Schutzschicht bedeckt, um in einem zweiten Beschichtungsvorgang ausschließlich die noch nicht beschichtete zweite Lichtaustrittsseite zu beschichten. Da aus ihr eine möglichst hohe Lichtintensität herausgestrahlt werden soll, muß sie eine geringe Reflektivität haben.

In Fig. 7 ist wiederum die elektrische Rauschleistung des Fabry-Pérot-Halbleiterlasers 15 als Funktion des an ihn angelegten Meßstroms abgebildet, wie sie der Steuerrechner 10 auch während der Beschichtung der zweiten Lichtaustrittsseite mißt. Dargestellt ist eine Kurve mit einem Peak I, wie sie zu Beginn dieses Beschichtungsvorgangs gemessen wird; der Verlauf dieser Kurve entspricht mit unwesentlichen Abweichungen dem der Kurve mit dem Peak III in Fig. 5, da das Entfernen der Schutzschicht an dieser Lichtaustrittsseite und das Aufbringen einer Schutzschicht an der anderen Lichtaustrittsseite keinen merklichen Einfluß auf das Rauschspektrum hat.

Entsprechend ergibt sich in Fig. 8, in der wieder die Reflektivität als Funktion der Schichtdicke aufgetragen ist, auch für die zweite Lichtaustrittsseite ein ähnlicher Verlauf mit einem Anfangswert I, zu dem eine Kurve mit einem Peak I gehört. Bei Beendigung der Beschichtung ist dann ein Wert II (Fig. 8) der Reflektivität erreicht, dem in Fig. 7 ein Peak II entspricht. Mit dem Erreichen dieses Wertes II (Fig. 8) ist das Ziel der beiden Beschichtungsvorgänge errreicht: alle Fabry-Pérot-Halbleiterlaser 15-19 haben je eine stark reflektierende und eine stark lichtdurchlässige Lichtaustrittsseite. Diese hat eine Lichtdurchlässigkeit von 95 %. Außerdem hat der Laserschwellstrom nach der Beschichtung den gleichen Wert wie vor der Beschichtung.

Die DFB-Halbleiterlaser befinden sich, wie oben bereits erwähnt, auf einem Riegel. Ihre Lichtaustrittsseiten werden von zwei einander gegenüberliegenden Seitenkanten des Riegels gebildet. Bei den DFB-Halbleiterlasern werden die Lichtaustrittsseiten in einem einzigen Beschichtungsprozeß gleichzeitig beschichtet, weil das Modenspektrum des DFB-Halbleiterlasers beeinflußt werden soll, damit er beispielsweise als einmodiger Sendelaser geeignet ist.

Ein Rauschspektrum des DFB-Halbleiterlasers in Fig. 9 zeigt Peaks I und II in der elektrischen Rauschleistung. Der DFB-Halbleiterlaser hat also zwei Schwellströme, die beispielsweise eine Stromstärke von 20 mA und 55 mA haben. Der Abstand zwischen ihnen beträgt also 35 mA. In diesem Bereich arbeitet der DFB-Halbleiterlaser einmodig mit einer Seitenmodenunterdrückung von mehr als 30 dB, während er oberhalb des Schwellstroms von 55 mA zweimodig mit einer Seitenmodenunterdrückung von weniger als 10 dB arbeitet.

Um diese Seitenmodenunterdrückung zu verbessern, werden die DFB-Halbleiterlaser in der Reaktionskammer 1 beschichtet. Dabei bleibt der Peak I (Fig. 10) an der gleichen Stelle des elektrischen Rauschspektrums erhalten, während der Peak II zu einem höheren Stromwert wandert, bis er beispielsweise eine Stromstärke von 150 mA oder 200 mA erreicht hat.

Auf diese Weise ist ein für die optische Nachrichtenübertragung bei 1550 nm geeigneter einmodiger DFB-Halbleiterlaser entstanden, der sich beispielsweise mit hohem Modulationshub elektrisch modulieren läßt.

Gemäß dem Beschichtungsverfahren für DFB-Halbleiterlaser lassen sich auch optische Wanderwellenverstärker beschichten, die entweder auf einem Riegel oder einem Wafer aufgedampft sind und die gleiche Schichtstruktur wie Fabry-Pérot-Halbleiterlaser haben. Sie werden in einem einzigen Beschichtgungsverfahren solange beschichtet, bis die Reflektivität ihrer Lichtaustrittsseiten minimal wird.

Auch andere optische Bauelemente, wie z.B. Photodioden oder Phototransistoren, lassen sich mittels der Auswertung elektrischer Rauschspektren mit einer dielektrischen Schicht beschichten, deren optische Parameter, z.B. die Reflektivität, sich optimieren lassen.

## Patentansprüche

1. Verfahren zur Beschichtung eines mit elektrischen Anschlüssen ausgestatteten optoelektronischen Bauelements mit einer dielektrischen Schicht, bei dem optische Parameter des Bauelements bestimmt und zur Steuerung der Schichtdicke verwandt werden,
**dadurch gekennzeichnet**, daß während der Beschichtung ein sägezahnförmiger Meßstrom über die elektrischen Anschlüsse durch das Bauelement geleitet und ein sich in dem Bauelement dem Meßstrom überlagerndes, optische Parameter des Bauelements wiedergebendes elektrisches Rauschspektrum aufgenommen und ausgewertet wird, und daß bei der Auswertung gewonnene Signale einem Steuerrechner zugeführt werden, der daraus Signale zur Steuerung des Beschichtungsvorganges erzeugt.

2. Verfahren nach Anspruch 1,
**dadurch gekennzeichnet**, daß ein Spektralanalysator das elektrische Rauschspektrum aufnimmt und die elektrische Rauschleistung des Bauelements mißt, und daß der Steuerrechner aus der elektrischen Rauschleistung des Bauelements als Funktion des durch es fließenden Meßstroms das Signal zur Steuerung der Schichtdicke gewinnt.

3. Verfahren nach Anspruch 1 oder 2,
**dadurch gekennzeichnet**, daß der Steuerrechner eine Stromquelle steuert, die den Meßstrom erzeugt.

4. Vorrichtung zur Durchführung des Verfahrens nach Anspruch 1 mit einem Beschichtungsreaktor (2), der eine Reaktionskammer (1) aufweist,
**dadurch gekennzeichnet**, daß das Bauelement (3) in der Reaktionskammer (1) enthalten und über einen elektrischen Anschluß (4) und eine Verzweigungsschaltung (6) einerseits mit einer Stromquelle (7) zur Erzeugung eines sägezahnförmigen Meßstroms und andererseits mit einem Spektralanalysator (8) verbunden ist, daß der Spektralanalysator (8) der Messung der Rauschleistung dient und einem Steuerrechner (10) vorgeschaltet ist, und daß der Ausgang des Steuerrechners über eine Steuerleitung (13) mit einer Beschichtungsanordnung (14) verbunden ist, die ebenfalls Teil des Beschichtungsreaktors (2) ist.

## Claims

1. Method of coating an optoelectronic component provided with electrical terminals with a dielectric layer, in which optical parameters of the component are determined and are used to control the laycr thickness, characterized in that, during the coating, a sawtooth-shaped measuring current is passed through the component via the electrical terminals and an electrical noise spectrum which is superimposed on the measuring current in the component and which reproduces optical parameters of the component is recorded and evaluated and in that signals obtained in the evaluation are fed to a control computer which generates signals for controlling the coating process therefrom.

2. Method according to Claim 1, characterized in that a spectral analyser records the electrical noise spectrum and measures the electrical noise power of the component and in that the control computer derives the signal for controlling the layer thickness from the electrical noise power of the component as a function of the measuring current flowing through it.

3. Method according to Claim 1 or 2, characterized in that the control computer controls a current source which generates the measuring current.

4. Device for performing the method according to Claim 1, comprising a coating reactor (2) which has a reaction chamber (1), characterized in that the component (3) is contained in the reaction chamber (1) and is connected via an electrical terminal (4) and a branch circuit (6), on the one hand, to a currcnt source (7) for generating a sawtooth-shaped measuring current and, on the other hand, to a spectral analyser (8), in that the spectral analyser (8) serves to measure the noise power and is connected upstream of a control computer (10) and in that the output of the control computer is connected via a control line (13) to a coating arrangement (14) which is also part of the coating reactor (2).

## Revendications

1. Procédé pour appliquer sur un composant optoélectronique muni de connexions électriques une couche diélectrique dans laquelle les propriétés optiques du composant sont définies et sont utilisés pour la commande de l'épaisseur de la couche, caractérisé en ce que, pendant l'application de la couche, un courant de mesure en dents de scie est conduit dans le composant par l'intermédiaire des connexions électriques, en ce qu'un spectre du bruit électrique se superposant au courant de mesure dans le composant, reproduisant les propriétés optiques du composant est enregistré et exploité, et en ce que les signaux acquis par l'exploitation sont conduits à un calculateur pilote, qui produit, à partir de ces signaux, des signaux de commande du procédé d'application d'une couche.

2. Procédé suivant la revendication 1, caractérisé en ce qu'un analyseur spectral enregistre le spectre du bruit électrique et mesure la puissance du bruit électrique du composant, et en ce que le calculateur pilote acquiert le signal de commande de l'épaisseur de la couche à partir de la puissance du bruit électrique du composant en fonction du courant de mesure le traversant.

3. Procédé suivant la revendication 1 ou 2, caractérisé en ce que le calculateur pilote commande une source de courant qui produit le courant de mesure.

4. Dispositif pour mettre en oeuvre le procédé de la revendication 1, comportant un réacteur (2) d'application de couche présentant une chambre de réaction (1), caractérisé en ce que le composant (3)est contenu dans la chambre de réaction (1) et est relié, par l'intermédiaire d'une connexion électrique (4) et d'un circuit de branchement (6), d'une part à une source de courant (7) pour produire un courant de mesure en dents de scie, et d'autre part à un analyseur spectral (8), en ce que l'analyseur spectral (8) sert à mesurer la puissance du bruit et est monté en amont d'un calculateur pilote (10), et en ce que la sortie du calculateur pilote est reliée, par l'intermédiaire d'une ligne pilote (13), à un dispositif d'application de couche (14) qui fait également partie du réacteur (2) d'application de couche.
